(19)

Europäisches
Patentamt
European
Patent Office
Office européen
des brevets

(11) **EP 3 401 963 A1**

(12) **EUROPEAN PATENT APPLICATION**

(43) Date of publication:
**14.11.2018 Bulletin 2018/46**

(51) Int Cl.:
***H01L 31/101*** (2006.01)   ***H01L 31/0352*** (2006.01)
***H01L 31/0304*** (2006.01)

(21) Application number: **18171586.3**

(22) Date of filing: **09.05.2018**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **11.05.2017   JP 2017094892**

(71) Applicants:
• **Sharp Kabushiki Kaisha
Sakai-shi
Osaka 590-8522 (JP)**
• **The University Of Tokyo
Tokyo 113-8654 (JP)**

(72) Inventors:
• **YOSHIKAWA, Hirofumi
Osaka, 590-8522 (JP)**
• **IZUMI, Makoto
Osaka, 590-8522 (JP)**
• **KITAZAWA, Tazuko
Osaka, 590-8522 (JP)**
• **KOTANI, Teruhisa
Osaka, 590-8522 (JP)**
• **ARAKAWA, Yasuhiko
Tokyo, 113-8654 (JP)**

(74) Representative: **Müller Hoffmann & Partner
Patentanwälte mbB
St.-Martin-Strasse 58
81541 München (DE)**

(54) **QUANTUM DOT INFRARED DETECTOR**

(57)     A quantum dot infrared detector includes a photoelectric conversion layer. The photoelectric conversion layer includes a quantum dot stacked structure in which quantum dot layers are stacked, each quantum dot layer including at least quantum dots, a underlayer for the quantum dots, and a partial cap layer at least partially covering the quantum dots. The underlayer is $Al_xGa_{1-x}As$ $(0 \leq x < 1)$, and the partial cap layer is $Al_yGa_{1-y}As$ $(0 \leq y < 1)$. When the lower of x and y is represented by z and a size of the quantum dots in a direction perpendicular to a stacking direction of the quantum dot stacked structure is represented by R (nm), z satisfies $z \geq 0.14 \times R - 1.6$, and the size of the quantum dots in the stacking direction is less than or equal to 0.5R.

FIG. 1

EP 3 401 963 A1

**Description**

CROSS-REFERENCE TO RELATED APPLICATIONS

This application claims the benefit of priority to Japanese Patent Application Number 2017-094892 filed on May 11, 2017. The entire contents of the above-identified application are hereby incorporated by reference.

BACKGROUND

The disclosure relates to a quantum dot infrared detector.

In the field of infrared detectors, infrared detectors having quantum dots continue to be researched and developed with the aim of increasing sensitivities. For example, quantum dot infrared detectors have been proposed which aim to increase sensitivities in middle- and far-infrared ranges by using transitions through a quantum level in a conduction band in a structure including quantum dots in an active layer, such as those disclosed in JP 2016-136585 A and Journal of Applied Physics, Vol. 107, 054504, 2010.

Unlike known thermal detectors such as bolometers and quantum detectors using bulk InGaAS, MCT (HgCdTe), and the like, infrared detectors having quantum dots have a narrow absorption region rather than a broad absorption region. This is caused by using an energy level made non-contiguous by quantum confinement effect.

In quantum dot infrared detectors, light absorption using transitions from a ground level in the conduction band to the quantum level in the quantum well layer and the conduction band in an intermediate layer is most common at present, with detection regions typically often being less than or equal to 8 $\mu$m.

On the other hand, the transition wavelength from the ground level in the conduction band to a first excited level (and a second excited level) is a longer wavelength range than the above-described region. In an InAs/GaAs quantum dot structure using GaAs in the underlayer and partial cap layer for the quantum dots, the wavelength is typically from 20 to 25 $\mu$m. However, when using an infrared detector, it is desirable to detect light in a region of from 8 to 14 $\mu$m (the atmospheric window), where there is little atmospheric absorption.

Accordingly, JP 2016-136585 A and Journal of Applied Physics, Vol. 107, 054504, 2010 disclose quantum dot structures in which AlAs is used in the underlayer and partial cap layer for the quantum dots. This reduces the transition wavelength from the ground level in the conduction band to the first excited level (and the second excited level) through an increase in the quantum confinement effect, and thus makes it possible to detect light in the 8- to 14-$\mu$m region.

When absorbing light using transitions through the ground level in the conduction band and the first excited level and second excited level in the conduction band, light polarized in an in-plane direction can be expected to be absorbed. This is because the typical shape of quantum dots formed through Stranski-Krastanov (S-K) growth resembles a lens shape, and thus the quantum dots are larger in the in-plane direction than in a stacking direction. In other words, the quantum level strongly influenced by the in-plane direction size is a lower energy level than the quantum level strongly influenced by the stacking direction size. Thus, the first excited level in the conduction band and the second excited level in the conduction band are quantum levels strongly influenced by the in-plane direction size, and polarization in the in-plane direction causes optical transitions from the ground level in the conduction band.

Accordingly, when light is incident perpendicular to the infrared detector, it is not necessary to provide a diffraction grating, ensure that light is incident on the infrared detector at an angle, and the like. Furthermore, the probability of transitions between the ground level and the first excited level (and the second excited level) is generally greater than the absorption between other sublevels, and thus higher sensitivities can be anticipated.

SUMMARY

JP 2016-136585 A and Journal of Applied Physics, Vol. 107, 054504, 2010 use AlAs in the underlayer and partial cap layer for the quantum dots. However, from the standpoint of crystal growth, it is known that Al-As has a stronger bonding energy than Ga-As and that Al has low migration. As such, it is easier for the surface of an AlAs film to become rougher than a GaAs film. This leads to the occurrence of dislocation and the like when layering quantum dot layers, and an increase in dark current causes a drop in the sensitivity of the quantum dot infrared detector. Furthermore, the detection signal cannot be strengthened by increasing the number of layers. In other words, the quantum dot structure cannot be expected to provide S/N improvement.

Accordingly, embodiments of the disclosure provide a quantum dot infrared detector in which the number of layers can be increased and light can be detected with high sensitivity in the 8- to 14-$\mu$m region.

Structure 1

According to an embodiment of the disclosure, a quantum dot infrared detector includes a quantum dot stacked structure. The quantum dot stacked structure is a structure in which quantum dot layers are stacked, each quantum dot layer including at least quantum dots, a underlayer for the quantum dots, and a partial cap layer at least partially covering the quantum dots. The underlayer is $Al_xGa_{1-x}As$ ($0 \leq x < 1$), and the partial cap layer is $Al_yGa_{1-y}As$ ($0 \leq y < 1$). When the lower of x and y is represented by z and a size of the quantum dots in a direction perpendicular to a stacking direction of the quantum dot stacked structure is represented by R (nm), z satisfies z ≥ 0.14 × R - 1.6, and the size of the quantum dots in the stacking direction is less than or equal to 0.5R.

Structure 2

In Structure 1, the quantum dot layers are doped with an impurity.

Structure 3

In Structure 1 or Structure 2, a light absorption region of the quantum dot stacked structure is present at at least from 8 to 14 μm. Additionally, photocurrent in a polarization direction perpendicular to the stacking direction is greater than photocurrent in a polarization direction of the stacking direction. Structure 4

In any one of Structure 1 to Structure 3, the quantum dot layers contain quantum dots having R satisfying

$$z \geq 0.15 \times R - 1.1.$$

Structure 5

In any one of Structure 1 to Structure 4, the quantum dots are InAs.

The quantum dot infrared detector according to embodiments of the disclosure can increase the number of layers and detect light with high sensitivity in the 8- to 14-μm region.

BRIEF DESCRIPTION OF THE DRAWINGS

The disclosure will be described with reference to the accompanying drawings, wherein like numbers reference like elements.

FIG. 1 is a cross-sectional view of a quantum dot infrared detector according to an embodiment of the disclosure.

FIGS. 2A and 2B are cross-sectional views illustrating different configurations of a quantum dot layer illustrated in FIG. 1.

FIG. 3 illustrates a first process in a method of manufacturing the quantum dot infrared detector illustrated in FIG. 1.

FIG. 4 illustrates a second process in the method of manufacturing the quantum dot infrared detector illustrated in FIG. 1.

FIGS. 5A and 5B are graphs illustrating a relationship between z and R.

FIG. 6 is a diagram illustrating an absorption spectrum result when h = 3 nm.

FIG. 7 is a diagram illustrating an absorption spectrum result when h = 4 nm.

FIG. 8 is a diagram illustrating an absorption spectrum result when h = 2 nm.

DESCRIPTION OF EMBODIMENTS

Embodiments of the present disclosure will be described in detail with reference to the drawings. Note that the same reference signs are assigned to the same or equivalent parts, and description thereof is not repeated.

Terms used in this specification will be described first.

A "quantum dot layer" is a layer including quantum dots, a wetting layer, an intermediate layer, a underlayer for the quantum dots, a partial cap layer for the quantum dots, an insertion layer, and the like.

A "quantum dot" is a semiconductor particle that has a particle size of 100 nm or less and is covered with a semiconductor material having a larger bandgap than the semiconductor material constituting the quantum dot. In Stranski-Krastanov (S-K) growth, a wetting layer is formed, and quantum dots are then grown.

A "underlayer for the quantum dots" is a layer serving as a base for growing quantum dots and a wetting layer.

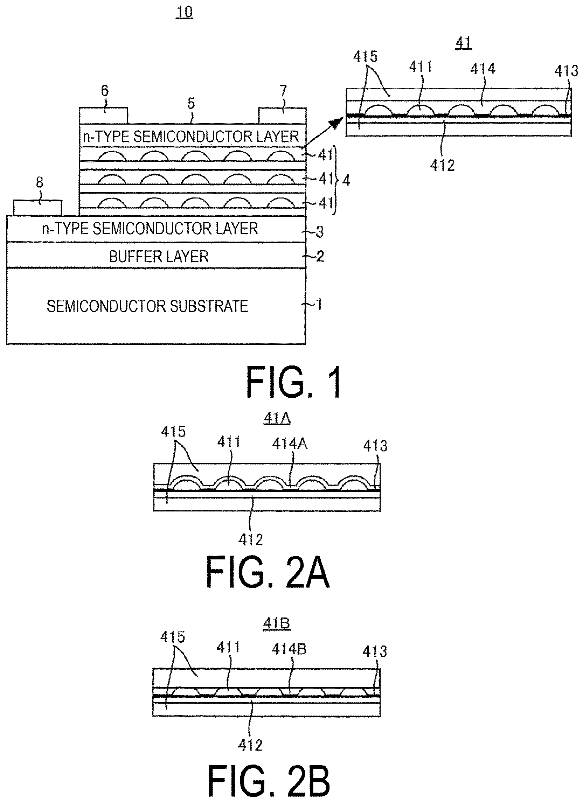

A "partial cap layer for the quantum dots" is a layer that is grown on top of the quantum dots, is constituted by a semiconductor material having a larger bandgap than the semiconductor material constituting the quantum dots, and at least partially covers the quantum dots. Although flat in FIG. 1 described below, the partial cap layer may have a shape that conforms to the shape of the quantum dots. Furthermore, although in FIG. 1 the partial cap layer has a thickness greater than a height of the quantum dots, the thickness may be less than or equal to the height of the quantum dots.

An "intermediate layer" is a layer, constituted by a semiconductor material having a larger bandgap than the semiconductor material constituting the quantum dots, and that serves as a matrix for the quantum dot layer. The intermediate layer may include the same semiconductor material as the underlayer for the quantum dots and the partial cap layer for the quantum dots.

FIG. 1 is a cross-sectional view of a quantum dot infrared detector according to an embodiment of the disclosure. As illustrated in FIG. 1, a quantum dot infrared detector 10 according to an embodiment of the disclosure includes a semiconductor substrate 1, a buffer layer 2, n-type semiconductor layers 3 and 5, a photoelectric conversion layer 4, and electrodes 6 to 8.

The buffer layer 2 is disposed on the semiconductor substrate 1, in contact with one surface of the semiconductor substrate 1. The n-type semiconductor layer 3 is disposed on the buffer layer 2, in contact with the buffer layer 2.

The photoelectric conversion layer 4 is disposed on the n-type semiconductor layer 3, in contact with the n-type semiconductor layer 3. The n-type semiconductor layer 5 is disposed on the photoelectric conversion layer 4, in contact with the photoelectric conversion layer 4.

The electrodes 6 and 7 are disposed separate from each other on the n-type semiconductor layer 5 in contact with the n-type semiconductor layer 5. The electrode 8 is disposed on the n-type semiconductor layer 3, in contact with the n-type semiconductor layer 3.

The semiconductor substrate 1 is formed of semi-insulating GaAs, for example. The buffer layer 2 is formed of GaAs, for example. The buffer layer 2 is from 100 nm to 500 nm thick, for example.

Each of the n-type semiconductor layers 3 and 5 is formed of n-$Al_{0.1}Ga_{0.9}As$, for example. Each of the n-type semiconductor layers 3 and 5 are from 100 nm to 1000 nm thick, for example.

Each of the electrodes 6 to 8 is an n-type electrode, and is formed of any one of Au/AuGeNi, Au-Ge/Ni/Au, Au/Ge, and Au/Ge/Ni/Au, for example. Each of the electrodes 6 to 8 are from 10 nm to 500 nm thick, for example.

The photoelectric conversion layer 4 has a stacked structure formed by stacking a plurality of quantum dot layers 41. Although FIG. 1 illustrates a case where three quantum dot layers 41 are stacked, it is sufficient for at least two quantum dot layers 41 to be stacked in the quantum dot infrared detector 10.

Each of the plurality of quantum dot layers 41 includes quantum dots 411, a underlayer 412 for the quantum dots 411, a wetting layer 413 for the quantum dots 411, a partial cap layer 414 for the quantum dots 411, and an intermediate layer 415.

The underlayer 412 is disposed below the quantum dots 411. The wetting layer 413 is disposed on the underlayer 412, in contact with the underlayer 412. The partial cap layer 414 is disposed on the quantum dots 411 and the wetting layer 413 so as to cover the quantum dots 411 and the wetting layer 413. Note that FIG. 1 illustrates a case where the partial cap layer 414 is thicker than the quantum dots 411. The intermediate layer 415 is disposed on both sides of the quantum dots 411, the underlayer 412, the wetting layer 413, and the partial cap layer 414.

Note that each quantum dot layer 41 may include an insertion layer and the like in addition to the quantum dots 411, the underlayer 412 for the quantum dots, wetting layer 413, the partial cap layer 414 for the quantum dots 411, and the intermediate layer 415.

It is generally sufficient for each quantum dot layer 41 to include at least the quantum dots 411, the underlayer 412 for the quantum dots 411, and the partial cap layer 414 for the quantum dots 411.

The material constituting the quantum dot layers 41 is not particularly limited, but is preferably a group III-V compound semiconductor.

The quantum dots 411 are preferably formed of a semiconductor material having a bandgap energy less than that of the intermediate layer 415.

Preferably, the materials constituting the quantum dot layers 41 are, for example, $In_xGa_{1-x}As$, $Al_xGa_{1-x}As$, $In_xGa_{1-x}P$, $GaAs_xSb_{1-x}$, AlSb, $InAs_xSb_{1-x}$, $Ga_xIn_{1-x}Sb$, $AlSb_xAs_{1-x}$, $AlAs_zSb_{1-z}$, $Al_yGa_{1-y}As_zSb_{1-z}$, $(Al_yGa_{1-y})_zIn_{1-z}P$, $GaAs_xP_{1-x}$, $Ga_yIn_{1-y}As_zP_{1-z}$, and $In_xAl_{1-x}As$ (in these materials, $0 \leq x \leq 1$, $0 \leq y \leq 1$, and $0 \leq z \leq 1$; the same applies hereinafter); and may be a mixed crystal thereof.

The materials constituting the quantum dot layers 41 may be a compound semiconductor formed of a fourth-group semiconductor or a third-group semiconductor material and a fifth-group semiconductor material in the periodic table, a compound semiconductor formed of a second-group semiconductor material and a fourth-group semiconductor material, or a mixed crystal material thereof. The materials constituting the quantum dot layers 41 may be a chalcopyrite-based material, or may be a semiconductor other than the chalcopyrite-based material.

The photoelectric conversion layer 4 may be an i-type semiconductor layer, or may be a semiconductor layer containing a p-type impurity or an n-type impurity.

In an embodiment of the disclosure, the photoelectric conversion layer 4 has a quantum dot stacked structure. The quantum dot stacked structure includes at least the quantum dots 411, the underlayer 412 for the quantum dots 411, and the partial cap layer 414 for the quantum dots 411. The underlayer 412 is $Al_xGa_{1-x}As$ ($0 \leq x < 1$), and the partial cap layer 414 is $Al_yGa_{1-y}As$ ($0 \leq y < 1$). When the lower of x and y is represented by z and a size of the quantum dots 411 in a direction perpendicular to the stacking direction of the quantum dot layers 41 is represented by R (nm), z satisfies $z \geq 0.14 \times R - 1.6$, and the size of the quantum dots 411 in the stacking direction of the quantum dot layers 41 is less than or equal to $0.5 \times R$.

By using AlGaAs in the underlayer 412 and the partial cap layer 414 for the quantum dots 411, the surface flatness of the underlayer 412 and the partial cap layer 414 can be improved while achieving a quantum confinement effect of the quantum dots 411. AlGaAs contains Ga, which has a higher migration than Al, makes it possible to improve the surface flatness of the film. Accordingly, a quantum dot infrared detector that suppresses the occurrence of dislocation and the like when increasing the number of quantum dot layers 41 can be manufactured.

The quantum confinement effect corresponding to the size of the quantum dots can also be increased by containing at least quantum dots 411 having a size in the stacking direction of less than or equal to $0.5 \times R$, where R (nm) is a size of the quantum dots 411 in a direction perpendicular to a stacking direction, and the numerical value z, which is the lower of x and y, satisfies $z \geq 0.14 \times R - 1.6$. Accordingly, light absorbency in regions with a wavelength less than or equal to 14 $\mu$m can be achieved by transitions between the ground level in the conduction band and the first excited level in the conduction band

(and the second excited level in the conduction band).

As described above, transitions between the ground level in the conduction band and the first excited level in the conduction band (and the second excited level in the conduction band) have a high absorption coefficient, and thus the sensitivity of the quantum dot infrared detector 10 can be increased. Furthermore, transitions between the ground level in the conduction band and the first excited level in the conduction band (and the second excited level in the conduction band) exhibit strong absorption of light polarized in a direction perpendicular to the stacking direction of the quantum dot layers 41, and thus photocurrent in the polarization direction perpendicular to the stacking direction is greater than photocurrent in the polarization direction of the stacking direction. This is because light polarized in the in-plane direction is strongly absorbed due to the first excited level in the conduction band and the second excited level in the conduction band being quantum levels strongly influenced by the in-plane direction size.

Photocurrent in the polarization direction perpendicular to the stacking direction of the quantum dot layers 41 and photocurrent in the polarization direction of the stacking direction can be compared by, for example, polishing the substrate edge of a sample so as to have an angle of 45 degrees relative to the stacking direction and causing light to be incident on the substrate edge through a polarizing plate. In other words, photocurrent in the polarization direction perpendicular to the stacking direction of the quantum dot layers 41 is compared with photocurrent in a polarization direction at 45 degrees relative to the stacking direction, and in a case where the photocurrent in the polarization direction perpendicular to the stacking direction is greater than the photocurrent in the polarization direction of the stacking direction, photocurrent in the polarization direction perpendicular to the stacking direction will be greater than photocurrent in a polarization direction at 45 degrees relative to the stacking direction.

On the other hand, in infrared detectors, using transitions strongly absorbing light polarized in the stacking direction of the quantum dot layers 41 normally causes a dramatic drop in sensitivity in the surface incidence used. It becomes necessary to adjust the polarization direction using a diffraction grating, use a configuration that causes incidence on the substrate edge as described above, and the like which leads to an increase in the size of the device, increased costs, and the like.

The region from 8 to 14 $\mu$m is called an "atmospheric window". In this region, there is almost no absorption by water vapor, oxygen, carbon dioxide, and the like, making it possible to detect infrared light efficiently. Based on the above, with the structure of the photoelectric conversion layer 4 according to an embodiment of the disclosure, the quantum confinement effect is strengthened through widening of the gaps of the underlayer 412 and the partial cap layer 414 for the quantum dots 411 and the effect of the size of the quantum dots 411, which makes it possible to put the transition wavelength between the ground level in the conduction band and the first excited level in the conduction band (and the second excited level in the conduction band) in the band of from 8 to 14 $\mu$m, while also increasing the number of high-quality layers in the quantum dot structure.

The photoelectric conversion layer 4 may be doped with an impurity. This enables inter-sublevel transitions to occur efficiently.

The photoelectric conversion layer 4 contains at least quantum dots 411 satisfying $z \geq 0.15 \times R - 1.1$. This makes it possible to make the transition wavelength between the ground level in the conduction band and the first excited level in the conduction band (and the second excited level in the conduction band) less than or equal to 10 $\mu$m. A radiation peak of human body temperature is present at from 9.5 to 10 $\mu$m, and thus people can be detected with high sensitivity.

The material of the quantum dots 411 is InAs, for example. This makes it possible to increase the quantum confinement effect.

FIGS. 2A and 2B are cross-sectional views illustrating different configurations of the quantum dot layer 41 illustrated in FIG. 1. The quantum dot layer 41 according to an embodiment of the disclosure may be formed as a quantum dot layer 41A, illustrated in FIG. 2A, or as a quantum dot layer 41B, illustrated in FIG. 2B.

As illustrated in FIG. 2A, the quantum dot layer 41A is the same as the quantum dot layer 41 aside from the partial cap layer 414 of the quantum dot layer 41 illustrated in FIG. 1 being replaced with a partial cap layer 414A.

The partial cap layer 414A is disposed on the quantum dots 411 and the wetting layer 413, conforming to the shape of the quantum dots 411.

As illustrated in FIG. 2B, the quantum dot layer 41B is the same as the quantum dot layer 41 aside from the partial cap layer 414 of the quantum dot layer 41 illustrated in FIG. 1 being replaced with a partial cap layer 414B.

The partial cap layer 414B has the same thickness as the quantum dots 411, and is disposed on the quantum dots 411 and the wetting layer 413.

In an embodiment of the disclosure, the partial cap layer may be configured as any of the partial cap layer 414 illustrated in FIG. 1 and the partial cap layers 414A and 414B illustrated in FIGS. 2A and 2B.

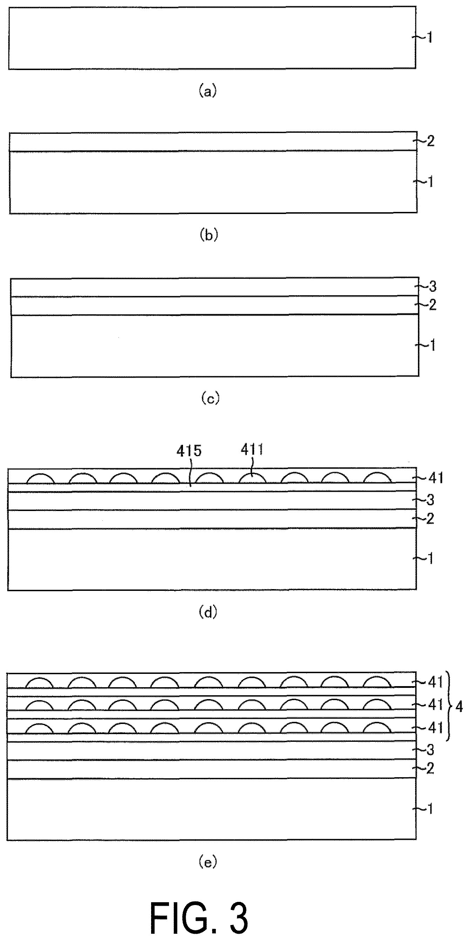

FIGS. 3 to 4 are diagrams illustrating first and second processes, respectively, in a method of manufacturing the quantum dot infrared detector 10 illustrated in FIG. 1. Furthermore, step (a) to step (g) illustrated in FIGS. 3 to 4 illustrate a single process including the first and second processes.

As illustrated in FIG. 3, when the manufacture of the quantum dot infrared detector 10 is started, a semiconductor substrate 1 formed of semi-insulating GaAs is placed in a molecular beam epitaxy (MBE) device (step (a) in FIG. 3).

The buffer layer 2 is then formed on the semiconductor substrate 1 through MBE (step (b) in FIG. 3). In this case, for example, a 200 nm-thick GaAs layer is formed as the buffer layer 2. Forming the buffer layer 2 can improve the crystallinity of the photoelectric conversion layer 4 to be formed on the buffer layer 2. As a result, an infrared detector in which high light receiving efficiency for the photoelectric conversion layer 4 is ensured can be provided.

After step (b), the n-type semiconductor layer 3 is formed on the buffer layer 2 through MBE (step (c) in FIG. 3). In this case, for example, a 500-nm n-$Al_{0.1}Ga_{0.9}As$ layer is formed as the n-type semiconductor layer 3.

Next, the quantum dot layer 41 containing the quantum dots 411 and the intermediate layer 415 is formed on the n-type semiconductor layer 3 through MBE (step (d) in FIG. 3).

In this case, the quantum dots 411 are formed through a method called Stranski-Krastanov (S-K) growth.

To be more specific, an $Al_{0.1}Ga_{0.9}As$ layer is crystal-grown as the intermediate layer 415, after which an $Al_{0.4}Ga_{0.6}As$ layer is crystal-grown as the underlayer 412 for the quantum dots. Then, the quantum dots 411 formed of InAs are formed through a self-assembly mechanism. An $Al_{0.4}Ga_{0.6}As$ layer is then crystal-grown as the partial cap layer 414 to embed the quantum dots 411. Further, an $Al_{0.1}Ga_{0.9}As$ layer is then crystal-grown as the intermediate layer, thus forming the quantum dot layer 41.

Then, the photoelectric conversion layer 4 having a structure in which the quantum dot layers 41 are stacked is formed on the n-type semiconductor layer 3 by repeating step (d) ten times, for example (step (e) in FIG. 3) .

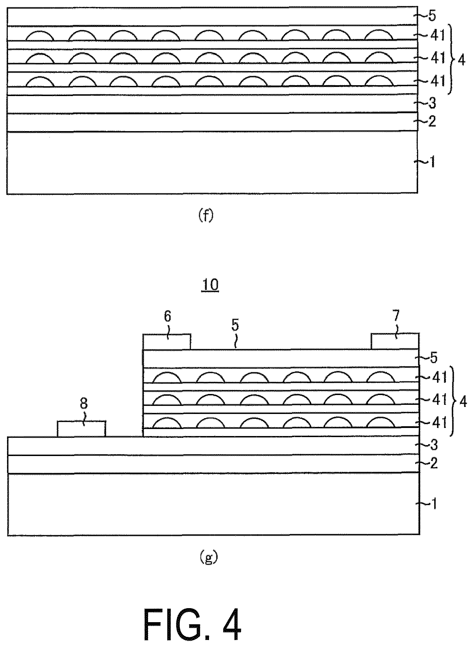

The n-type semiconductor layer 5 is then formed on the photoelectric conversion layer 4 through MBE (step (f) in FIG. 4). In this case, for example, a 200 nm-thick n-$Al_{0.1}Ga_{0.9}As$ layer is crystal-grown as the n-type semiconductor layer 5. An nin structure is formed as a result.

Next, the multilayer body is removed from the MBE device, the photoelectric conversion layer 4 and the n-type semiconductor layer 5 are partially removed using photolithography and wet etching, the electrodes 6 and 7 are formed on the n-type semiconductor layer 5, and the electrode 8 is formed on the n-type semiconductor layer 3. This completes the quantum dot infrared detector 10 (step (g) in FIG. 4).

Si, for example, can be used as the n-type dopant in the above-described manufacturing process. Au is preferably used for the electrodes 6 to 8, and the electrodes 6 to 8 are preferably formed by vacuum deposition through resistance-heating deposition.

When infrared light is incident on the quantum dot infrared detector 10, electrons are excited by the photoelectric conversion layer 4 absorbing the light. The excited electrons move through an electrical field, and is obtained by the electrodes 6 to 8 as photocurrent.

Using AlGaAs in the underlayer 412 and partial cap layer 414 for the quantum dots 411 makes it possible to improve the surface flatness of the underlayer 412 and the partial cap layer 414 while obtaining the quantum confinement effect of the quantum dots, and the quantum dot infrared detector 10 in which the number of the quantum dot layers 41 can be increased while suppressing the occurrence of dislocation and the like can be manufactured.

The quantum confinement effect corresponding to the size of the quantum dots can also be increased by containing at least quantum dots 411 having a size in the stacking direction of less than or equal to $0.5 \times R$, where R (nm) is a size of the quantum dots 411 in a direction perpendicular to a stacking direction and the numerical value z, which is the lower of x and y, satisfies $z \geq 0.14 \times R - 1.6$. Accordingly, light absorbency in a region with a wavelength of from 8 to 14 $\mu$m can be achieved by transitions between the ground level in the conduction band and the first excited level in the conduction band (and the second excited level in the conduction band). As described above, transitions between the ground level in the conduction band and the first excited level in the conduction band (and the second excited level in the conduction band) have a high absorption coefficient in the polarization direction perpendicular to the stacking direction, and thus the sensitivity of the quantum dot infrared detector 10 can be increased.

The above-described relationships "$z \geq 0.14 \times R - 1.6$" and "$z \geq 0.15 \times R - 1.1$" are relationships obtained by the inventors of the disclosure carrying out simulations of band structures in various quantum dot structures.

Attention is given to using AlGaAs (or GaAs) as a quantum dot barrier layer for the purpose of suppressing the occurrence of dislocation and the like when layering quantum dot layers, and to the size of the quantum dots in the direction perpendicular to the stacking direction for the purpose of shortening the transition wavelength between the ground level in the conduction band and the first excited level in the conduction band (and the second excited level in the conduction band) (increasing the quantum confinement effect). Specifically, the band structure was simulated by using an 8-band k-p Hamiltonian plane-wave expansion method in consideration of the influences of strain and the piezoelectric field effect.

To simplify calculations, the simulations were carried out for quantum dots surrounded by the barrier layer material, assuming that the underlayer and partial cap layer for the quantum dots would have a sufficient thickness with respect to the quantum confinement effect.

Furthermore, when the barrier layer material is AlGaAs, an increased Al composition increases the quantum confinement effect and shortens the transition wavelength between the ground level in the conduction band and the first excited level in the conduction band (and the second excited level in the conduction band). Thus, when the underlayer is $Al_xGa_{1-x}As$ (where $0 \leq x < 1$) and the partial cap layer is $Al_yGa_{1-y}As$ (where $0 \leq y < 1$), in a case where the band is calculated using the numerical value of z, which is the lower of x and y, it can be seen that the above-described transition wavelength is at least on the short side from the calculated value. Specifically, indium arsenide (InAs) was used as the quantum dot material, and gallium arsenide (GaAs) or aluminum gallium arsenide (AlGaAs) was used as the barrier layer material. The quantum dots had a lens shape including a 0.5 nm-thick wetting layer, and the diameter of the quantum dots in the in-plane direction was calculated as R = from 8 to 20 nm.

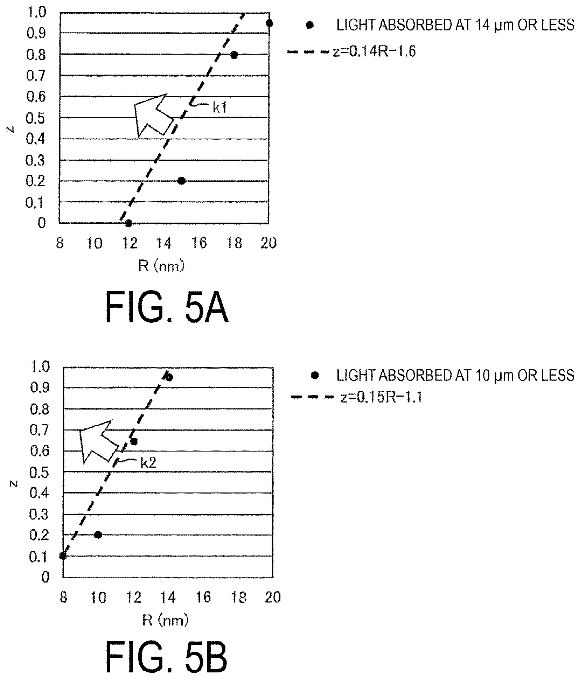

FIGS. 5A and 5B are graphs illustrating a relationship between z and R. In FIGS. 5A and 5B, the vertical axis represents z and the horizontal axis represents R.

FIGS. 5A and 5B plot combinations of Al compositions for the barrier layer material ($Al_zGa_{1-z}As$ ($0 \leq z < 1$) and the diameter of the quantum dots in the in-plane direction at which the transition wavelength between the ground level in the conduction band and the first excited level in the conduction band (and the second excited level in the conduction band) is less than or equal to 14 $\mu$m (FIG. 5A) and less than or equal to 10 $\mu$m (FIG. 5B).

The straight lines k1 and k2 are approximations satisfying all the data at which the transition wavelength is less than or equal to 14 $\mu$m and less than or equal to 10 pm, respectively, and have been made to satisfy each combination. Accordingly, the straight line k1 is expressed as an approximation of z = 0.14R - 1.6, and the straight line k2 is expressed as an approximation of z = 0.15R - 1.1.

The approximations on the sides indicated by the arrows indicate that the transition wavelength is less than or equal to 14 $\mu$m or less than or equal to 10 $\mu$m. When detecting light at greater than or equal to 8 $\mu$m and less than or equal to 14 $\mu$m, adjustments may be made as appropriate while ensuring that the above-described relationships are satisfied.

Evaluation Experiments

Numerical calculations were carried out for the quantum dot infrared detector 10 according to an embodiment of the disclosure.

The band structure was simulated by using an 8-band k·p Hamiltonian plane-wave expansion method in consideration of the influences of strain and the piezoelectric field effect. To simplify the calculations, the simulations were carried out for the quantum dots 411 surrounded by the barrier layer material, assuming that the quantum dot underlayer 412 and partial cap layer 414 would have a sufficient thickness with respect to the quantum confinement effect.

The absorption peak was evaluated according to a magnitude $\Delta E$ of an energy gap between the ground level and the first excited level in the conduction band. The absorption spectrum was calculated for (100) polarized light as the light polarized in the in-plane direction of the quantum dots 411 and (001) polarized light as the light polarized in the stacking direction of the quantum dots 411.

Experimental Example 1

In this experimental example, indium arsenide (InAs) was used as the quantum dot material and gallium arsenide (GaAs) was used as the barrier layer material.

The quantum dots had a lens shape including a 0.5 nm-thick wetting layer, and the diameter of the quantum dots in the in-plane direction was R = 10 nm. The calculations were carried out with three sizes for the quantum dots in the stacking direction (the height), namely h = 2 nm, 3 nm, and 4 nm. The distance between the quantum dots in the in-plane direction was 20 nm, and the distance between the quantum dots in the stacking direction was 20 nm.

As a result, it was found that $\Delta E$ was 94 meV when h = 2 nm, 112 meV when h = 3 nm, and 110 meV when h = 4 nm, and that a light absorption peak was present in a region of from 11 to 13 $\mu$m.

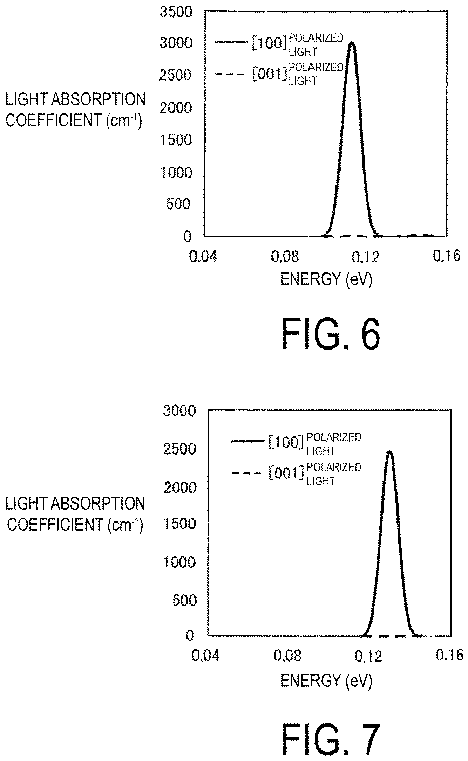

FIG. 6 is a diagram illustrating an absorption spectrum result when h = 3 nm. In FIG. 6, the vertical axis represents the light absorption coefficient, and the horizontal axis represents energy.

As illustrated in FIG. 6, an absorption peak of (100) polarized light is present at 112 meV due to transitions between the ground level in the conduction band and the first excited level in the conduction band (and the second excited level in the conduction band). On the other hand, there is almost no absorption of (001) polarized light.

In this experimental example, the underlayer 412 was $Al_xGa_{1-x}As$ (x = 0) and the partial cap layer 414 was $Al_yGa_{1-y}As$ (y = 0), and thus z was 0. The size R in the direction perpendicular to the stacking direction of the quantum dots 411 (the diameter in the in-plane direction) was 10 nm, satisfying $z \geq 0.14 \times R - 1.6$ ($0 \geq -0.2$). Thus, the quantum dot infrared detector 10 according to the embodiment of the disclosure can detect light at less than or equal to 14 $\mu$m.

A case where the diameter of the quantum dots 411 in the in-plane direction was large at R = 20 nm was also calculated for comparison. The calculations were made with three sizes for the quantum dots 411 in the stacking direction (the height), namely h = 2 nm, 5 nm, and 8 nm.

As a result, it was found that $\Delta E$ was 63 meV when h = 2 nm, 64 meV when h = 5 nm, and 52 meV when h = 8 nm, and that a light absorption peak was present in a region of from 20 to 24 $\mu$m.

A light absorption peak thus could not be provided at from 8 to 14 $\mu$m, which is the atmospheric window. In this case, $z \geq 0.14 \times R - 1.6$ was not satisfied (0 ≥ 1.2).

Based on the above, the quantum confinement effect in the in-plane direction can be increased by setting the diameter of the quantum dots 411 in the in-plane direction less than or equal to a certain size in accordance with the barrier layer material constituting the quantum dot structure. Accordingly, light can be detected at less than or equal to 14 μm through transitions between the ground level in the conduction band and the first excited level in the conduction band (and the second excited level in the conduction band). In this experimental example, by using gallium arsenide as the barrier layer material and setting the diameter of the quantum dots in the in-plane direction to 10 nm, light could be detected at less than or equal to 14 μm through transitions between the ground level in the conduction band and the first excited level in the conduction band (and the second excited level in the conduction band).

Experimental Example 2

In this experimental example, indium arsenide (InAs) was used as the quantum dot material and aluminum gallium arsenide ($Al_{0.2}Ga_{0.8}As$) was used as the barrier layer material. The quantum dots 411 had a lens shape including a 0.5 nm-thick wetting layer, and the diameter of the quantum dots 411 in the in-plane direction was R = 10 nm. The calculations were made with three sizes for the quantum dots 411 in the stacking direction (the height), namely h = 2 nm, 3 nm, and 4 nm. The distance between the quantum dots 411 in the in-plane direction was 20 nm, and the distance between the quantum dots 411 in the stacking direction was 20 nm.

As a result, the quantum confinement effect was increased by using aluminum gallium arsenide as the barrier layer material. It was found that ΔE was 126 meV when h = 2 nm, 131 meV when h = 3 nm, and 124 meV when h = 4 nm, and that a light absorption peak was present at from 9.5 to 10 μm. This can coincide with the radiation peak of human body temperature, which makes efficient detection possible.

In this experimental example, the underlayer 412 was $Al_xGa_{1-x}As$ (x = 0.2) and the partial cap layer 414 was $Al_yGa_{1-y}As$ (y = 0.2), and thus z was 0.2. The size R in the direction perpendicular to the stacking direction of the quantum dots 411 (the diameter in the in-plane direction) was 10 nm, satisfying z ≥ 0.14 × R - 1.6 (0.2 ≥ -0.2). The quantum dot infrared detector 10 can thus detect light at less than or equal to 14 μm.

The same numerical calculations were carried out for a case where aluminum gallium arsenide ($Al_{0.4}Ga_{0.6}As$) was used as the barrier layer material, as an additional calculation.

As a result, it was found that ΔE was 136 meV when h = 2 nm, 139 meV when h = 3 nm, and 129 meV when h = 4 nm, and that a light absorption peak was present at from 9 to 10 μm.

FIG. 7 is a diagram illustrating an absorption spectrum result when h = 4 nm. In FIG. 7, the vertical axis represents the light absorption coefficient, and the horizontal axis represents energy.

As illustrated in FIG. 7, an absorption peak of (100) polarized light is present at 129 meV due to transitions between the ground level in the conduction band and the first excited level in the conduction band (and the second excited level in the conduction band). On the other hand, there is almost no absorption of (001) polarized light.

In this experimental example, the underlayer 412 was $Al_xGa_{1-x}As$ (x = 0.4) and the partial cap layer 414 was $Al_yGa_{1-y}As$ (y = 0.4), and thus z was 0.4. The size R in the direction perpendicular to the stacking direction of the quantum dots 411 (the diameter in the in-plane direction) was 10 nm, satisfying z ≥ 0.15 × R - 1.1 (0.4 ≥ 0.4). The quantum dot infrared detector 10 can thus detect light at less than or equal to 10 μm.

In this experimental example, by using aluminum gallium arsenide as the barrier layer material and setting the diameter of the quantum dots 411 in the in-plane direction to 10 nm, light could be detected at less than or equal to 14 μm through transitions between the ground level in the conduction band and the first excited level in the conduction band (and the second excited level in the conduction band). Furthermore, by increasing the Al composition of the aluminum gallium arsenide, light could be detected at less than or equal to 10 μm.

Experimental Example 3

In this experimental example, indium arsenide (InAs) was used as the quantum dot material and aluminum gallium arsenide ($Al_{0.8}Ga_{0.2}As$) was used as the barrier layer material. The quantum dots 411 had a lens shape including a 0.5 nm-thick wetting layer, and the diameter of the quantum dots 411 in the in-plane direction was R = 15 nm. The calculations were made with three sizes for the quantum dots 411 in the stacking direction (the height), namely h = 2 nm, 3 nm, and 4 nm. The distance between the quantum dots 411 in the in-plane direction was 20 nm, and the distance between the quantum dots 411 in the stacking direction was 20 nm.

As a result, the quantum confinement effect was further increased by using aluminum gallium arsenide having a high aluminum composition as the barrier layer material. It was found that ΔE was 108 meV when h = 2 nm, 106 meV when h = 3 nm, and 97 meV when h = 4 nm, and that a light absorption peak was present at from 11 to 13 μm.

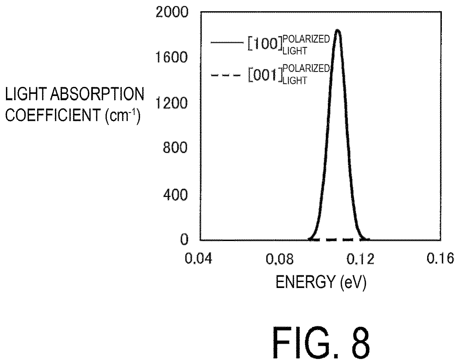

FIG. 8 is a diagram illustrating an absorption spectrum result when h = 2 nm. In FIG. 8, the vertical axis represents the light absorption coefficient, and the horizontal axis represents energy.

As illustrated in FIG. 8, an absorption peak of (100) polarized light is present at 108 meV due to transitions between the ground level in the conduction band and the first excited level in the conduction band (and the second excited level in the conduction band). On the other hand, there is almost no absorption of (001) polarized light.

In this experimental example, the underlayer 412 was $Al_xGa_{1-x}As$ (x = 0.8) and the partial cap layer 414 was $Al_yGa_{1-y}As$ (y = 0.8), and thus z was 0.8. The size R in the direction perpendicular to the stacking direction of the quantum dots 411 (the diameter in the in-plane direction) was 15 nm, satisfying $z \geq 0.14 \times R - 1.6$ ($0.8 \geq 0.5$). The quantum dot infrared detector 10 can thus detect light at less than or equal to 14 μm.

In this experimental example, by using aluminum gallium arsenide as the barrier layer material and setting the diameter of the quantum dots 411 in the in-plane direction to 15 nm, light could be detected at less than or equal to 14 μm through transitions between the ground level in the conduction band and the first excited level in the conduction band (and the second excited level in the conduction band).

Example 1

The quantum dot infrared detector 10 according to an embodiment of the disclosure may be a quantum dot infrared detector transferred onto another substrate. For example, a flexible infrared detector can be obtained by transferring onto a flexible substrate.

Specifically, an epitaxial layer grown on a substrate is separated from the substrate and transferred onto a flexible substrate including an electrode layer. The electrode layer may be manufactured after the transfer. Such a structure allows a highly-flexible infrared detector to be obtained. Furthermore, such a structure allows the epitaxial growth substrate to be reused, which leads to reduced costs. The substrate onto which the detector is transferred need not be a flexible substrate, and may be a metal foil or the like.

Example 2

The quantum dot infrared detector 10 according to an embodiment of the disclosure may be an infrared detector using a luminescence converter. By providing a photoelectric conversion layer on one surface of a luminescence converter including a wavelength conversion layer formed of one or more wavelength conversion materials, infrared light incident on the wavelength conversion layer is concentrated and wavelength-converted, and is then incident on the photoelectric conversion layer. An improvement in the photoelectric conversion efficiency of the infrared detector can be anticipated as a result.

Here, "luminescence converter" refers to a configuration including a wavelength conversion material, and is a molded body in which glass, resin, or the like are mixed to fix the wavelength conversion material.

A luminescence converter is a device in which infrared light is incident from a front surface, wavelength conversion and light radiation are repeated within the luminescence converter, light is fully reflected at the front surface and a rear surface, and concentrated and wavelength-converted infrared light is ultimately emitted from four edge surfaces of a rectangular parallelepiped. The photoelectric conversion efficiency of the infrared detector can be improved by providing photoelectric conversion layers on each of the four edge surfaces of the luminescence converter. Such a structure allows the infrared detector to be configured using an amount of materials approximately equivalent to the area of the edge surfaces, which reduces the amount of materials used and the cost. The infrared detector is also made lighter, which makes it possible to use the infrared detector anywhere, such as by affixing the detector to a window or building material, or mounting the detector on a roof.

The embodiments disclosed herein are for illustrative purposes in any respect and should not be construed as limiting. The scope of the present disclosure is defined by the scope of the claims rather than the description of the embodiments and is intended to include any modifications within the scope and meaning equivalent to the claims.

INDUSTRIAL APPLICABILITY

The disclosure is applied in quantum dot infrared detectors.

While preferred embodiments of the present invention have been described above, it is to be understood that variations and modifications will be apparent to those skilled in the art without departing from the scope and spirit of the present invention. The scope of the present invention, therefore, is to be determined solely by the following claims.

**Claims**

1. A quantum dot infrared detector comprising a quantum dot stacked structure in which quantum dot layers are stacked, each quantum dot layer including at least quantum dots, a underlayer for the quantum dots, and a partial cap layer at least partially covering the quantum dots,
   wherein the underlayer includes $Al_xGa_{1-x}As$, where $0 \leq x < 1$;
   the partial cap layer includes $Al_yGa_{1-y}As$, where $0 \leq y < 1$; and
   when the lower of x and y is represented by z and a size of the quantum dots in a direction perpendicular to a stacking direction of the quantum dot stacked structure is represented by R (nm), z satisfies $z \geq 0.14 \times R - 1.6$, and the size of the quantum dots in the stacking direction is less than or equal to 0.5R.

2. The quantum dot infrared detector according to claim 1,
   wherein the quantum dot layers are doped with an impurity.

3.  The quantum dot infrared detector according to claim 1 or 2,
    wherein a light absorption region of the quantum dot stacked structure is present at at least from 8 to 14 μm; and
    photocurrent in a polarization direction perpendicular to the stacking direction is greater than photocurrent in a polarization direction of the stacking direction.

4.  The quantum dot infrared detector according to any one of claims 1 to 3,
    wherein the quantum dot layers contain quantum dots having R satisfying $z \geq 0.15 \times R - 1.1$.

5.  The quantum dot infrared detector according to any one of claims 1 to 4,
    wherein the quantum dots include InAs.

10

41

415 411 414 413

6 5 7

n-TYPE SEMICONDUCTOR LAYER

~41
~41 } 4
~41

412

8

n-TYPE SEMICONDUCTOR LAYER ~3

BUFFER LAYER ~2

SEMICONDUCTOR SUBSTRATE ~1

# FIG. 1

41A

415 411 414A 413

412

# FIG. 2A

41B

415 411 414B 413

412

# FIG. 2B

(a)

(b)

(c)

415    411

(d)

(e)

# FIG. 3

(f)

(g)

# FIG. 4

FIG. 5A

FIG. 5B

FIG. 6

FIG. 7

FIG. 8

Europäisches
Patentamt

European
Patent Office

Office européen
des brevets

## EUROPEAN SEARCH REPORT

Application Number

EP 18 17 1586

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | SCHRAMBOECK M ET AL: "InAs/AlGaAs QDs for intersubband devices", SUPERLATTICES AND MICROSTRUCTURES, ACADEMIC PRESS, LONDON, GB, vol. 44, no. 4-5, 3 December 2007 (2007-12-03), pages 411-415, XP025545915, ISSN: 0749-6036, DOI: 10.1016/J.SPMI.2007.10.010 [retrieved on 2007-12-03] * abstract; figures 1,2,5b * * page 411 - page 414 * | 1-3,5 | INV. H01L31/101 H01L31/0352 H01L31/0304 |
| X | TING DAVID ET AL: "Submonolayer quantum dot infrared photodetector", APPLIED PHYSICS LETTERS, vol. 94, no. 11, 111107, 17 March 2009 (2009-03-17), pages 111107-1-111107-3, XP012118390, ISSN: 0003-6951, DOI: 10.1063/1.3095812 * abstract; figures 1,2 * * page 1, left-hand column - page 2, right-hand column * | 1-5 | |
| X | SHAHZADEH MOHAMMADREZA ET AL: "The effects of wetting layer on electronic and optical properties of intersubband P-to-S transitions in strained dome-shaped InAs/GaAs quantum dots", AIP ADVANCES, vol. 4, no. 6, 067113, 4 June 2014 (2014-06-04), pages 1-15, XP012186165, DOI: 10.1063/1.4881980 [retrieved on 1901-01-01] * abstract; figures 1-8 * * page 1 * * page 3 - page 6 * | 1-5 | TECHNICAL FIELDS SEARCHED (IPC) H01L |

-/--

The present search report has been drawn up for all claims

| Place of search | Date of completion of the search | Examiner |
|---|---|---|
| Berlin | 5 September 2018 | Sagol, Bülent Erol |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

page 1 of 2

Europäisches
Patentamt

European
Patent Office

Office européen
des brevets

**EUROPEAN SEARCH REPORT**

Application Number

EP 18 17 1586

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2013/146844 A1 (SUGIZAKI GORO [JP] ET AL) 13 June 2013 (2013-06-13)<br>* abstract; figures 2C,6 *<br>* paragraphs [0002] - [0022], [0049], [0070] - [0073] * | 1,2,4,5 | |
| X | US 2010/032651 A1 (OKAMURA TOSHIHIRO [JP] ET AL) 11 February 2010 (2010-02-11)<br>* abstract; figures 1-2,5-8 *<br>* paragraphs [0019] - [0025], [0039], [0063] - [0073] * | 1-3,5 | |

TECHNICAL FIELDS
SEARCHED      (IPC)

The present search report has been drawn up for all claims

| Place of search | Date of completion of the search | Examiner |
|---|---|---|
| Berlin | 5 September 2018 | Sagol, Bülent Erol |

EPO FORM 1503 03.82 (P04C01)

## ANNEX TO THE EUROPEAN SEARCH REPORT
## ON EUROPEAN PATENT APPLICATION NO.

EP 18 17 1586

This annex lists the patent family members relating to the patent documents cited in the above-mentioned European search report.
The members are as contained in the European Patent Office EDP file on
The European Patent Office is in no way liable for these particulars which are merely given for the purpose of information.

05-09-2018

| Patent document cited in search report | | Publication date | Patent family member(s) | | Publication date |
|---|---|---|---|---|---|
| US 2013146844 | A1 | 13-06-2013 | JP 2013120880 A | | 17-06-2013 |
| | | | US 2013146844 A1 | | 13-06-2013 |
| US 2010032651 | A1 | 11-02-2010 | JP 2009065142 A | | 26-03-2009 |
| | | | US 2010032651 A1 | | 11-02-2010 |

**EP 3 401 963 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2017094892 A

- JP 2016136585 A

**Non-patent literature cited in the description**

- *Journal of Applied Physics,* 2010, vol. 107, 054504